(19) Europäisches Patentamt
European Patent Office
Office européen des brevets

(11) EP 2 642 665 A1

(12) DEMANDE DE BREVET EUROPEEN

(43) Date de publication:
25.09.2013 Bulletin 2013/39

(51) Int Cl.:
*H03L 7/20* (2006.01)

(21) Numéro de dépôt: 13159852.6

(22) Date de dépôt: 19.03.2013

(84) Etats contractants désignés:
AL AT BE BG CH CY CZ DE DK EE ES FI FR GB
GR HR HU IE IS IT LI LT LU LV MC MK MT NL NO
PL PT RO RS SE SI SK SM TR
Etats d'extension désignés:
BA ME

(30) Priorité: 19.03.2012 FR 1200817

(71) Demandeur: Thales
92200 Neuilly Sur Seine (FR)

(72) Inventeurs:
• Souchard, Eric
49309 Cholet (FR)
• Bertram, Pierre
60100 Creil (FR)

(74) Mandataire: Blot, Philippe Robert Emile
Cabinet Lavoix
2, place d'Estienne d'Orves
75441 Paris Cedex 09 (FR)

(54) **Générateur de fréquence pour un équipement radiofréquence et procédé pour générer un signal de sortie**

(57) L'invention concerne un générateur de fréquence pour un équipement radiofréquence pour générer un signal de sortie ayant une fréquence de sortie ($F_s$) prédéterminée, le générateur de fréquence comprenant : un oscillateur local (3) pour générer un signal de référence ayant une fréquence de référence ($F_{ref}$), et une boucle à verrouillage de phase (5), la boucle à verrouillage de phase étant munie d'un oscillateur contrôlé (25) générant le signal de sortie ayant la fréquence de sortie ($F_s$) en fonction d'un signal à son entrée, et d'un comparateur (21) fournissant un signal à l'oscillateur contrôlé (25) en fonction d'une comparaison (C) de phase et/ou de fréquence d'un premier signal de comparaison (Fcomp1) basé sur un signal d'entrée appliqué à une première entrée (16) de la boucle à verrouillage de phase (5) avec un deuxième signal de comparaison (Fcomp2) basé sur le signal de sortie, le générateur de fréquence (1) comprenant en outre au moins un générateur d'harmonique (7) propre à générer, à partir du signal de référence, un signal d'harmonique comportant une harmonique prédéterminée ($F_H$) du signal de référence, le générateur de fréquence étant propre à appliquer le signal d'harmonique de l'un des générateurs d'harmonique à la première entrée (16) de la boucle à verrouillage de phase (5). En outre, la présente invention concerne un procédé pour générer un signal de sortie.

FIG.1

EP 2 642 665 A1

**EP 2 642 665 A1**

**Description**

L'invention concerne un générateur de fréquence pour un équipement radiofréquence pour générer un signal de sortie ayant une fréquence de sortie prédéterminée, le générateur de fréquence comprenant : un oscillateur local pour générer un signal de référence ayant une fréquence de référence, et une boucle à verrouillage de phase, la boucle à verrouillage de phase étant munie d'un oscillateur contrôlé générant le signal de sortie ayant la fréquence de sortie en fonction d'un signal à son entrée, et d'un comparateur fournissant un signal à l'oscillateur contrôlé en fonction d'une comparaison de phase et/ou de fréquence d'un premier signal de comparaison basé sur un signal d'entrée appliqué à une première entrée de la boucle à verrouillage de phase avec un deuxième signal de comparaison basé sur le signal de sortie.

En outre, l'invention concerne un procédé pour générer un signal de sortie ayant une fréquence de sortie prédéterminée en utilisant un oscillateur local pour générer un signal de référence ayant une fréquence de référence et une boucle à verrouillage de phase, la boucle à verrouillage de phase étant munie d'un oscillateur contrôlé générant le signal de sortie ayant la fréquence de sortie en fonction d'un signal à son entrée, et d'un comparateur fournissant un signal au oscillateur contrôlé en fonction d'une comparaison de phase et/ou de fréquence d'un premier signal de comparaison basé sur un signal d'entrée appliqué à une première entrée de la boucle à verrouillage de phase avec un deuxième signal de comparaison basé sur le signal de sortie.

Dans les équipements de transmission à radiofréquence, les signaux de sortie générés par le générateur de fréquence sont utilisés pour sélectionner un canal dans le cas d'une émission ou pour accorder l'équipement à un canal à utiliser dans le cas d'une réception. Par exemple, une fréquence de sortie $F_s$ est choisie dans un ensemble de fréquences discrètes prédéfinies s'exprimant sous la forme $F_s = k \times \Delta F_s$, avec kmin $\leq$ k $\leq$ kmax, k un entier et $\Delta F_s$ une fréquence choisie en fonction des besoins de l'application.

Dans une architecture de base, un générateur de fréquence comprend un oscillateur local pour générer un signal de référence. Ce signal de référence, qui a une fréquence de référence Fref, est appliqué à une boucle à verrouillage de phase dans laquelle la fréquence du signal de référence est divisée par un premier diviseur. Le signal obtenu qui a une fréquence de comparaison Fcomp est appliqué à une première entrée d'un comparateur de phase. Le signal de sortie du générateur de fréquence est également soumis à une division de fréquence dans un deuxième diviseur de fréquence et est ensuite appliqué à une deuxième entrée du comparateur de phase. Le comparateur fournit le résultat de la comparaison entre la première entrée et la deuxième entrée via un filtre passe-bas à un oscillateur contrôlé en tension qui génère le signal de sortie avec la fréquence $F_s$ en fonction de son signal d'entrée. Généralement, de tels générateurs de fréquence sont pilotés par un contrôleur qui choisit les rapports de division du premier et du deuxième diviseur en fonction de la fréquence de sortie $F_s$ voulue.

Une partie du signal de sortie de l'oscillateur contrôlé en tension est amplifiée pour l'usage par une chaîne de transmission et/ou de réception radiofréquence et une autre partie est renvoyée, comme décrit précédemment, au comparateur par le biais du deuxième diviseur.

Une telle architecture permet une réalisation de pas de fréquence $\Delta F_s$ très fins par rapport à la fréquence de sortie $F_s$. Il existe des cas, dans lequel le spectre délivré par le générateur de fréquence est affecté des raies parasites, qui apparaissent en particulier dans le cas où $F_s$ est proche d'une harmonique de la fréquence de référence Fref du signal de référence directement appliqué à la boucle à verrouillage de phase ou est proche d'une harmonique de la fréquence de comparaison Fcomp.

Afin de palier cet inconvénient, l'architecture décrite précédemment est souvent modifiée par une adjonction d'un circuit supplémentaire entre l'oscillateur local et la boucle à verrouillage de phase, par exemple un circuit à base d'un synthétiseur numérique direct (DDS) ou une deuxième boucle à verrouillage de phase. Ce circuit supplémentaire est également piloté par le contrôleur de façon de s'affranchir des cas de relations défavorables entre la fréquence de référence Fref appliquée à la boucle à verrouillage de phase, la fréquence de comparaison Fcomp et la fréquence de sortie $F_s$.

Néanmoins, une telle solution nécessite un circuit supplémentaire complexe qui entraine une consommation supplémentaire importante et un encombrement inacceptable pour l'usage d'un tel générateur de fréquence dans d'un équipement portatif. De plus, le circuit supplémentaire pour la génération de fréquence de référence variable entraine une dégradation de la qualité du signal généré par le circuit supplémentaire comparée à celle du signal de référence d'origine.

Le but de la demande est de proposer un générateur de fréquence et un procédé qui produisent un signal de sortie peu perturbé avec un circuit peu consommateur et peu encombrant.

Ce but est atteint, conformément à l'invention, par un générateur de fréquence un générateur de fréquence pour un équipement radiofréquence pour générer un signal de sortie ayant une fréquence de sortie prédéterminée, le générateur de fréquence comprenant : un oscillateur local pour générer un signal de référence ayant une fréquence de référence, et une boucle à verrouillage de phase, la boucle à verrouillage de phase étant munie d'un oscillateur contrôlé générant le signal de sortie ayant la fréquence de sortie en fonction d'un signal à son entrée, et d'un comparateur

2

fournissant un signal à l'oscillateur contrôlé en fonction d'une comparaison de phase et/ou de fréquence d'un premier signal de comparaison basé sur un signal d'entrée appliqué à une première entrée de la boucle à verrouillage de phase avec un deuxième signal de comparaison basé sur le signal de sortie, le générateur de fréquence comprenant en outre au moins un générateur d'harmonique propre à générer, à partir du signal de référence, un signal d'harmonique comportant une harmonique prédéterminée du signal de référence, le générateur de fréquence étant propre à appliquer le signal d'harmonique de l'un des générateurs d'harmonique à la première entrée de la boucle à verrouillage de phase.

Selon des caractéristiques avantageuses :

- la boucle à verrouillage de phase est munie en outre d'un premier diviseur de fréquence, le premier diviseur de fréquence étant propre à diviser la fréquence du signal d'entrée pour générer le premier signal de comparaison, et/ou d'un deuxième diviseur de fréquence, le deuxième diviseur de fréquence étant propre à diviser la fréquence de sortie du signal de sortie pour générer le deuxième signal de comparaison ;
- le générateur d'harmonique est propre à générer une harmonique impaire du signal de référence ;
- le générateur d'harmonique comprend un dispositif propre à générer une pluralité d'harmoniques du signal de référence, en particulier une pluralité d'harmoniques impaires, par exemple un générateur d'un signal carré ayant la fréquence de référence du signal de référence, et un dispositif d'extraction d'une harmonique propre à sélectionner l'harmonique prédéterminée à générer par le générateur d'harmonique ;
- l'oscillateur local est connecté par au moins deux voies parallèles et au moins un commutateur à la première entrée de la boucle à verrouillage de phase, le ou les commutateurs étant propres à sélectionner l'une des voies ;
- un premier commutateur est connecté entre l'oscillateur local et les au moins deux voies et un deuxième commutateur est connecté entre les au moins deux voies et la première entrée de la boucle à verrouillage de phase ;
- il est propre à appliquer le signal de référence ayant la fréquence de référence à la première entrée lors de la sélection d'une première voie ;
- au moins une deuxième voie munie de l'un des générateurs d'harmonique de façon que lors de la sélection d'une deuxième voie, le signal d'harmonique est appliqué à la première entrée ; et/ou
- le générateur de fréquence comprend en outre un dispositif de sélection propre à choisir l'une des voies en fonction de la fréquence de sortie du signal de sortie à générer.

En outre, ce but est atteint, conformément à l'invention, par un procédé pour générer un signal de sortie ayant une fréquence de sortie prédéterminée en utilisant un oscillateur local pour générer un signal de référence ayant une fréquence de référence et une boucle à verrouillage de phase, la boucle à verrouillage de phase étant munie d'un oscillateur contrôlé générant le signal de sortie ayant la fréquence de sortie en fonction d'un signal à son entrée, et d'un comparateur fournissant un signal au oscillateur contrôlé en fonction d'une comparaison de phase et/ou de fréquence d'un premier signal de comparaison basé sur un signal d'entrée appliqué à une première entrée de la boucle à verrouillage de phase avec un deuxième signal de comparaison basé sur le signal de sortie, le procédé comprenant : la sélection d'une fréquence à appliquer à la première entrée parmi la fréquence de référence de l'oscillateur local et une fréquence d'harmonique prédéterminée du signal de référence, la génération, à partir du signal de référence, d'un signal d'harmonique ayant la fréquence d'harmonique prédéterminée du signal de référence, et l'application du signal d'harmonique à la première entrée de la boucle à verrouillage de phase.

Selon des caractéristiques avantageuses :

- la sélection de la fréquence à appliquer à la première entrée est faite en fonction de la fréquence de sortie du signal de sortie.

D'autres caractéristiques avantageuses de la présente invention ressortiront de la description faite ci-dessous, en référence aux dessins, qui illustrent un exemple de réalisation dépourvu de tout caractère limitatif et dans lesquels :

- la figure 1 est un circuit schématique d'un générateur de fréquence pour un équipement d'émission ou de réception à radiofréquence,
- la figure 2 est un circuit d'une génération d'une harmonique du générateur de fréquence de la figure 1, et
- la figure 3 montre un organigramme d'un procédé selon l'invention.

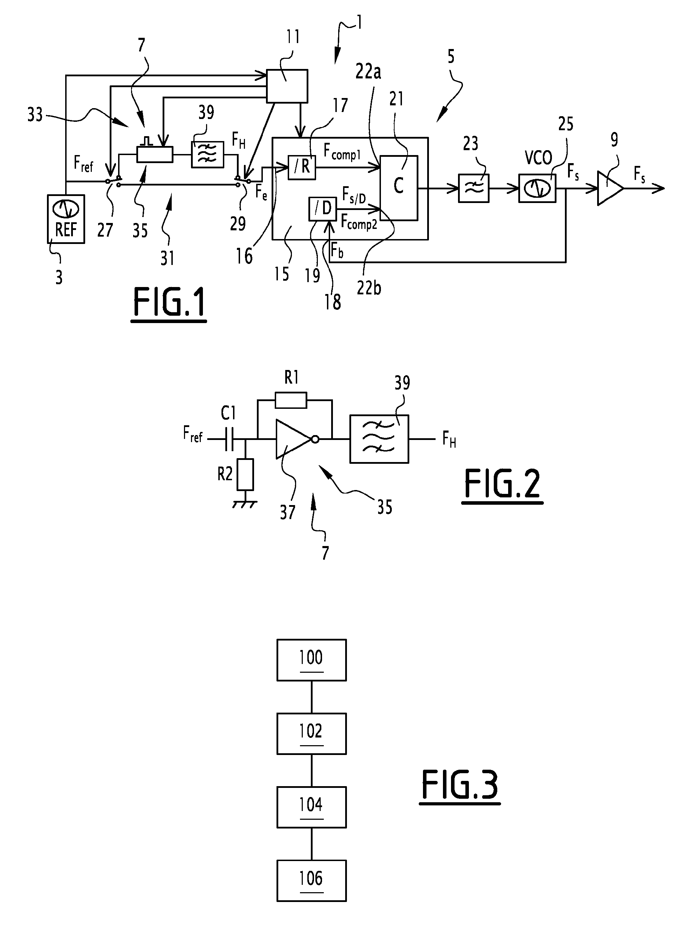

Le générateur de fréquence 1 de la figure 1 est utilisé dans un équipement de radiofréquence pour une émission ou une réception depuis une chaîne radiofréquence. Le générateur de fréquence 1 génère un signal de sortie ayant une fréquence de sortie $F_S$. Le signal de sortie est utilisé pour, en cas d'une émission, sélectionner un canal prédéterminé ou pour, en cas d'une réception, accorder l'équipement à un canal prédéterminé. La fréquence de sortie $F_S$ est choisie dans un ensemble de fréquences discrètes prédéfinies ayant un écart $\Delta F_S$ entre elles s'exprimant sous la forme $F_S = k \times \Delta F_S$, avec kmin $\leq$ k $\leq$ kmax, k un entier et $\Delta F_S$ une fréquence choisie en fonction des besoins de l'application.

Le générateur de fréquence 1 comprend un oscillateur local 3 qui génère un signal de référence ayant une fréquence de référence Fref, une boucle à verrouillage de phase 5, un générateur d'harmonique 7 propre à générer une harmonique prédéterminée d'un signal fourni au générateur d'harmonique, un amplificateur 9 pour amplifier le signal de sortie, et un contrôleur 11.

Dans un premier temps, la boucle à verrouillage de phase 5 est détaillée, puis, le circuit comprenant le générateur d'harmonique 7 agencé entre l'oscillateur local 3 et la boucle à verrouillage de phase 5.

La boucle à verrouillage de phase 5 comprend un composant électronique 15, par exemple une puce, pourvu d'une première entrée 16 reliée à un premier diviseur 17, d'une seconde entrée 18 reliée à un deuxième diviseur 19 et d'un comparateur de phase ou de fréquence 21.

La première entrée 16 de la boucle à verrouillage de phase est connectée au premier diviseur 17 pour lui fournir un signal d'entrée ayant la fréquence d'entrée Fe. Le premier diviseur 17 est propre à diviser la fréquence d'entrée Fe pour générer à sa sortie un premier signal de comparaison ayant la fréquence de comparaison Fcomp1. La sortie du premier diviseur 17 est connectée à une première entrée 22a du comparateur de phase 21. Le rapport de division du premier diviseur 17 est R. Donc, Fcomp1=Fe/R.

Le deuxième diviseur 19 est propre à diviser une fréquence d'un signal de boucle Fb qui est appliqué à la deuxième entrée 18 de la boucle à verrouillage de phase pour générer à sa sortie un deuxième signal de comparaison ayant la fréquence de comparaison Fcomp2. La sortie du deuxième diviseur 19 est connectée à une deuxième entrée 22b du comparateur de phase 21. Le rapport de division D du deuxième diviseur 19 est variable. Par exemple, le deuxième diviseur 19 est un diviseur fractionnaire. Donc, Fcomp2=Fb/D.

Le comparateur de phase 21 est propre à comparer les phases et/ou fréquences des signaux appliqués à sa première entrée 22a et à sa deuxième entrée 22b, notamment Fcomp1 et Fcomp2. En fonction de la comparaison C entre Fcomp1 et Fcomp2, le comparateur de phase 21 est propre à générer un signal de tension de contrôle à sa sortie. La sortie du comparateur de phase 21 est connectée à un filtre passe-bas 23 de la boucle à verrouillage de phase 5.

La boucle à verrouillage de phase 5 comprend en outre un oscillateur contrôlé en tension 25 (VCO). Le filtre passe-bas 23 est connecté à l'oscillateur contrôlé en tension 25 pour lui fournir le signal de contrôle filtré. L'oscillateur contrôlé en tension 25 est un oscillateur dont la fréquence de sortie varie en fonction de la tension du signal de contrôle filtré. L'oscillateur contrôlé en tension 25 est propre à générer le signal de sortie ayant la fréquence de sortie $F_s$.

La sortie de l'oscillateur contrôlé en tension 25 est connectée d'une part à l'amplificateur 9 et d'autre part à la deuxième entrée 18 de la boucle à verrouillage de phase 5. Le signal de boucle correspond alors au signal de sortie, donc Fb=$F_s$. La fréquence de sortie $F_s$ est alors divisée par le deuxième diviseur 19 pour être appliquée à la deuxième entrée 22b du comparateur de phase ou de fréquence 21. Alors, Fcomp2=$F_s$/D.

L'amplificateur 9 est propre à amplifier le signal de sortie pour le fournir à une chaîne de réception et/ou d'émission de l'équipement.

Le contrôleur 11 pilote la boucle à verrouillage de phase 5, en particulier pour fixer les rapports de division R, D du premier diviseur 17 et du deuxième diviseur 19 en fonction de la fréquence de sortie $F_s$ souhaitée. Le contrôleur 11 est, dans un autre mode de réalisation, une matrice de portes logiques programmables (FPGA - Field Programmable Gate Array). Par exemple, le contrôleur 11 a stocké un tableau dans sa mémoire dans lequel pour chaque fréquence de sortie $F_s$ le signal d'entrée à appliquer, le rapport de division R du premier diviseur 17, et/ou le rapport de division D du deuxième diviseur 19 sont stockés. Par exemple, le tableau est généré lors de la conception du générateur de fréquence 1.

Lors du fonctionnement de la boucle à verrouillage de phase, le deuxième signal de comparaison est asservi sur la fréquence et la phase du premier signal de comparaison grâce aux effets de l'autorégulation de la boucle à verrouillage de phase. Donc, Fcomp1=Fcomp2.

Ci-dessous, le circuit comprenant le générateur d'harmonique 7 agencé entre l'oscillateur local 3 et la boucle à verrouillage de phase 5 est expliqué.

Le générateur de fréquence 1 comprend deux commutateurs 27, 29 propres à basculer sous commande du contrôleur entre une première voie 31 et une deuxième voie 33 qui connectent sélectivement le premier commutateur 27 au deuxième commutateur 29. Le premier commutateur 27 est connecté en sortie de l'oscillateur local 3, et le deuxième commutateur 29 est connecté à la première entrée 16 de la boucle à verrouillage de phase 5. Donc, l'oscillateur local 3 est propre à fournir le signal de référence au premier commutateur 27 qui le dirige par l'une des voies 31, 33 au deuxième commutateur 29 puis à la première entrée 16.

Le générateur d'harmonique 7 est agencé dans la deuxième voie 33. Le générateur d'harmonique est alors propre à générer un signal d'harmonique ayant une unique fréquence d'harmonique $F_H$ du signal de référence. Les commutateurs 27, 29 sont agencés en amont et en aval du générateur d'harmonique 7 suivant le sens du signal de référence. Le deuxième commutateur 29 connecte alors le générateur d'harmonique 7 à la boucle à verrouillage de phase 5, en particulier à sa première entrée 16.

La première voie 31 est une connexion directe, sans traitement d'un signal traversant cette voie, entre le premier commutateur 27 et le deuxième commutateur 29.

EP 2 642 665 A1

De cette façon soit le signal de référence est fourni par la deuxième voie 33 au générateur d'harmonique 7 et le signal d'harmonique est appliqué à la première entrée 16 de la boucle de verrouillage de phase 5, soit le signal de référence est directement appliqué à la première entrée 16 de la boucle à verrouillage de phase 5 par la première voie 31.

Les deux commutateurs 27, 29 et le générateur d'harmonique 7 sont pilotés par le contrôleur 11. Donc, le contrôleur 11 est propre à sélectionner l'une des voies 31, 33. De plus, le contrôleur 11 est propre à mettre en fonction et à mettre hors fonction au moins une partie du générateur d'harmonique 7.

L'oscillateur local 3 est connecté au contrôleur 11 pour lui fournir le signal de référence.

Lors de l'implantation du générateur de fréquence, la première voie 31 et la deuxième voie 33 sont séparées physiquement pour éviter des couplages parasites entre elles. De plus, l'oscillateur local 3 est bien séparé du composant 15 de la boucle à verrouillage de phase 5 pour éviter des perturbations du signal de sortie, en particulier lorsqu'une harmonique du signal de référence est utilisée en tant que signal d'entrée.

Par exemple, à cet effet, une paroi isolante des ondes électromagnétiques est implantée entre la première voie et la deuxième voie ainsi qu'entre l'oscillateur local 3 et le composant 15.

Dans un mode de réalisation, une pluralité de générateurs d'harmonique 7 est agencée en parallèle chacun dans une voie. Chaque générateur d'harmonique génère une harmonique particulière. Dans ce mode de réalisation, les commutateurs sont propres à choisir l'une des voies pour l'application l'une des harmoniques ou le signal de référence à la première entrée 16 de la boucle à verrouillage de phase 5. Ce mode de réalisation permet un plus grand nombre de configurations.

Le générateur d'harmonique 7 est propre à être mis en fonction rapidement et à être arrêté lorsque la deuxième voie 33 n'est pas utilisée afin de diminuer la consommation et les problèmes des diaphonies qui pourraient réduire la performance du générateur de fréquence selon l'invention. Par exemple, le contrôleur 11 est propre à arrêter complètement ou partiellement le générateur d'harmonique 7. Les commutateurs 27, 29 ne consomment rien au repos. Les composants pour réaliser la première voie 31 et la deuxième voie 32 entrainent un surcoût global négligeable pour un équipement radiofréquence.

La figure 2 montre un mode de réalisation d'un générateur d'harmonique 7, le générateur d'harmonique 7 générant une seule harmonique comprend un dispositif pour la génération d'une pluralité d'harmoniques 35, 37 et un dispositif d'extraction 39 pour sélectionner l'une des harmoniques.

Par exemple, le dispositif pour la génération d'une pluralité d'harmoniques est un générateur de signal carré 35 comprenant une porte logique 37, par exemple un inverseur logique 37. Le générateur d'harmonique 7 comprend à son entrée un condensateur C1 qui est connecté à l'entrée de l'inverseur logique 37. Le signal de référence est injecté au condensateur C1. Une première résistance R1 est connectée en parallèle de l'inverseur logique 37. Le générateur de signal carré 35 est propre à créer un signal carré. Le spectre d'un signal carré idéal comprend que des harmoniques impaires. Néanmoins, le spectre réel comporte aussi des harmoniques pairs. Une résistance optionnelle R2 est propre à parfaire le rapport cyclique du signal carré tout en effaçant ou en minimisant au maximum la puissance des harmoniques paires pour obtenir un spectre aussi pur que possible. Lors de l'arrêt ou mise hors fonction du générateur d'harmonique, ses composants actifs, ici la porte logique 37, sont mis hors fonction.

La sortie du générateur du signal carré 35 est connectée au dispositif d'extraction 39, ici un filtre passe-bande 39 propre à sélectionner l'une des harmoniques générée. Par exemple, le filtre passe-bande est centré sur la fréquence de l'harmonique à sélectionner.

Dans un mode de réalisation, au lieu d'un filtre passe-bande 39 fixe un filtre passe-bande 39 variable est utilisé qui est asservi par le contrôleur 11. De cette façon le générateur de fréquence a un plus grand nombre de choix de fréquences à appliquer à la première entrée 16 de la boucle à verrouillage de phase 5.

Dans la suite le fonctionnement du générateur de fréquences 1 est expliqué.

Le générateur de fréquence 1 est propre à choisir une valeur de Fcomp1 et Fe telle que $F_s$ ne soit pas proche d'un multiple de ces fréquences. Donc, le cas où $F_s$ est approximativement égale à k x Fe ou $F_s$ est approximativement égale à I x Fcomp1, avec k,l des entiers sont à éviter.

Généralement, la fréquence de sortie $F_s$ du signal de sortie du générateur de fréquence 1 est :

$F_s$=Fcomp1 x D, avec Fcomp1=Fe/R et D = N+Frac/Mod, avec Fe étant la fréquence d'entrée du signal d'entrée de la boucle à verrouillage de phase, R étant le rapport de division appliqué à la fréquence d'entrée Fe par le premier diviseur 17, et N et Frac/Mod étant respectivement la partie entière et la partie fractionnaire du rapport de division du deuxième diviseur 19 appliqué au signal de sortie ayant la fréquence $F_s$. Fcomp1 est la fréquence à laquelle s'effectue la comparaison, c'est-à-dire la fréquence du premier signal de comparaison.

Par exemple, pour changer la fréquence de sortie, le rapport de division D du deuxième diviseur 19 est modifié. La distance entre deux fréquences discrètes adjacentes à générer dépend alors de la fréquence Fcomp1 du premier signal de comparaison la fréquence de référence et, dans le cas d'une division fractionnaire, du dénominateur Mod de la partie fractionnaire du rapport de division D du deuxième diviseur 19. Par exemple, dans le cas d'un rapport de division D entier, la distance entre deux fréquence discrètes adjacentes est $\Delta F_s$=Fcomp1. Dans le cas d'un rapport de division D fractionnaire (D = N+Frac/Mod) la distance entre deux fréquences discrètes à générer est $\Delta F_s$=Fcomp1/Mod.

La distance $\Delta F_s$ est, dans le mode de réalisation décrit, très fin par rapport à la fréquence de sortie $F_s$. Par exemple, $\Delta F_s$ est environ 25kHz pour une fréquence de sortie $F_s$ d'une plusieurs centaines de MHz.

Dans la suite, un exemple est donné à l'aide de l'organigramme de la figure 3 pour le cas où le générateur de fréquence 1 doit synthétiser une fréquence $F_s$ approximativement égale à 10.Fref. La fréquence à synthétiser $F_s$ est déterminée à l'étape 100.

La fréquence $F_s$ exacte sera $F_s$=10.Fref+$\Delta$f, avec $\Delta$f=n x $\Delta F_s$ proche de 0 par rapport à $F_s$ (n un nombre entier), car $F_s$ est beaucoup plus important que $\Delta F_s$. Quand la fréquence de sortie est proche d'un multiple de Fref, le spectre sera pollué par des raies à $F_s \pm \Delta$f.

Le contrôleur décide à l'étape 102 si le signal de référence ayant la fréquence de référence Fref est directement appliqué à la première entrée 16 de la boucle à verrouillage de phase 5 ou si une harmonique du signal de référence générée par le générateur d'harmonique 7 est appliquée à la première entrée 16 de la boucle à verrouillage de phase 5.

Dans le cas de l'exemple, le contrôleur 11 décide d'appliquer une harmonique impaire de la fréquence de référence Fref de l'oscillateur local 3, par exemple la troisième harmonique. Alors, $F_H$=3.Fref.

Dans la suite, à l'étape 104, le contrôleur 11 commande les commutateurs 27, 29 de façon que le signal de référence de l'oscillateur local 3 est appliqué au générateur d'harmonique 7. De plus, le contrôleur met en fonction le générateur d'harmonique 7. Lors du fonctionnement du générateur d'harmonique 7, l'inverseur logique 37 crée un signal carré comprenant les harmoniques impaires du signal de référence. Donc, le signal en sortie de l'inverseur 37 comprend des raies harmoniques aux fréquences $F_c$ = (m+1) .Fref, avec m un nombre entier. Ensuite, le signal carré est filtre par le filtre passe- bande 39 qui est, par exemple, centré sur la troisième harmonique. Le signal d'harmonique en sortie du générateur d'harmonique 7 a alors une fréquence $F_H$=3.Fref. Le signal d'entrée à la boucle à verrouillage de phase 5 a donc une fréquence Fe=3.Fref.

A l'étape 106, les rapports de division R, D pour le premier diviseur 17 et pour le deuxième diviseur 19 sont appliqués dans la boucle à verrouillage de phase 5. Dans un mode de réalisation, le rapport de division du premier diviseur 17 est un nombre entier, par exemple 2. Donc, le contrôleur 11 choisit les rapports de division R, D du premier et du deuxième diviseur en fonction de la fréquence de sortie $F_s$ voulue, par exemple à partir des valeurs stockées dans le tableau dans la mémoire du contrôleur 11.

La fréquence du premier signal de comparaison à la première entrée 22a du comparateur 21 est Fcomp1=Fe/2=3.Fref/2, en utilisant R=2.

Dans ce cas, on peut calculer l'écart entre la fréquence de sortie $F_s$ et la plus proche harmonique de Fe :

$$F_s=10.\text{Fref}+\Delta f=10.\text{Fe}/3 +\Delta f=3.\text{Fe}+1/3.\text{Fe}+\Delta f.$$

L'écart entre la fréquence de sortie $F_s$ et la plus proche harmonique de la fréquence d'entrée Fe utilisée est alors 1/3 Fe+$\Delta$f.

Sans l'application du générateur d'harmonique, l'écart entre la plus proche harmonique de la fréquence d'entrée Fe=Fref pourrait être que $\Delta$f, car $F_S$=10.Fref+$\Delta$f=10.Fe+$\Delta$f.

Donc, l'écart entre la plus proche harmonique du signal d'entrée utilisée et la fréquence du signal de sortie est augmenté de façon considérable.

La réponse en fréquence de la boucle à verrouillage de phase (PLL) se comporte comme un passe-bas, la fréquence de coupure étant très inférieure à Fe, par exemple inférieure à Fe/3. Cet effet atténue naturellement les raies ayant une distance supérieure à 1/3 Fe+$\Delta$f de $F_S$.

De même, on peut calculer l'écart entre la fréquence de sortie $F_s$ et la plus proche harmonique de Fcomp1 :

$$F_s=10.\text{Fref}+\Delta f =10.2.\text{Fcomp1}/3+\Delta f =7.\text{Fcomp1}+(-1/3.\text{Fcomp1}+\Delta f), \text{ avec Fref} = 2.\text{Fcomp1}/3$$

Donc, l'écart entre $F_s$ et la plus proche harmonique de la fréquence de comparaison Fcomp1 utilisée est 1/3.Fcomp1- $\Delta$f. Sans utilisation du générateur d'harmonique, l'écart entre la plus proche harmonique de la fréquence de comparaison Fcomp1 et la fréquence de sortie $F_s$ ne serait que $\Delta$f, car $F_s$=10.Fref+$\Delta$f= 20.Fcomp1+$\Delta$f.

Cet exemple démontre que l'application directe la fréquence de l'oscillateur de référence aboutit à un cas défavorable. L'emploi d'une harmonique impaire de cette même fréquence résout ce problème.

Si le contrôleur décide à l'étape 102 en fonction de la fréquence de sortie $F_s$ désirée que le signal de référence ayant la fréquence de référence Fref soit directement appliqué à la première entrée 16 de la boucle à verrouillage de phase 5, le contrôleur 11 commande à l'étape 104 les commutateurs 27, 29 pour sélectionner la première voie 31. De plus, le contrôleur met hors fonction le générateur d'harmonique 7.

Ensuite, à l'étape 106, les rapports de division R, D pour le premier diviseur 17 et pour le deuxième diviseur 19 sont appliqués.

Selon l'invention, la sélection de la voie 31, 33 s'effectue par le contrôleur 11 qui commute la bonne voie 31, 33 en fonction de la fréquence de sortie $F_s$ désirée.

Un avantage de cette approche réside dans le fait qu'aucune dégradation significative du bruit sur la fréquence de référence de l'oscillateur local 3 n'est introduite. Le générateur de fréquence et le procédé de l'invention permettent donc de résoudre les problèmes de raies sur la fréquence synthétisée sans dégrader la performance globale du bruit du générateur de fréquence.

## Revendications

1. Générateur de fréquence (1) pour un équipement radiofréquence pour générer un signal de sortie ayant une fréquence de sortie ($F_s$) prédéterminée, le générateur de fréquence comprenant :

   un oscillateur local (3) pour générer un signal de référence ayant une fréquence de référence (Fref), et
   une boucle à verrouillage de phase (5), la boucle à verrouillage de phase étant munie d'un oscillateur contrôlé (25) générant le signal de sortie ayant la fréquence de sortie ($F_s$) en fonction d'un signal à son entrée, et d'un comparateur (21) fournissant un signal à l'oscillateur contrôlé (25) en fonction d'une comparaison (C) de phase et/ou de fréquence d'un premier signal de comparaison (Fcomp1) basé sur un signal d'entrée appliqué à une première entrée (16) de la boucle à verrouillage de phase (5) avec un deuxième signal de comparaison (Fcomp2) basé sur le signal de sortie,
   **caractérisé en ce que** le générateur de fréquence (1) comprend en outre au moins un générateur d'harmonique (7) propre à générer, à partir du signal de référence, un signal d'harmonique comportant une harmonique prédéterminée ($F_H$) du signal de référence, le générateur de fréquence étant propre à appliquer le signal d'harmonique de l'un des générateurs d'harmonique à la première entrée (16) de la boucle à verrouillage de phase (5).

2. Générateur de fréquence selon la revendication 1, **caractérisé en ce que** la boucle à verrouillage de phase est munie en outre d'un premier diviseur de fréquence (17), le premier diviseur de fréquence étant propre à diviser la fréquence du signal d'entrée pour générer le premier signal de comparaison (Fcomp1), et/ou d'un deuxième diviseur de fréquence (19), le deuxième diviseur de fréquence (19) étant propre à diviser la fréquence de sortie ($F_s$) du signal de sortie pour générer le deuxième signal de comparaison (Fcomp2).

3. Générateur de fréquence selon la revendication 1 ou 2, **caractérisé en ce que** le générateur d'harmonique (7) est propre à générer une harmonique impaire du signal de référence (Fref).

4. Générateur de fréquence selon l'une des revendications précédentes, **caractérisé en ce que** le générateur d'harmonique (7) comprend un dispositif (35) propre à générer une pluralité d'harmoniques du signal de référence, en particulier une pluralité d'harmoniques impaires, par exemple un générateur d'un signal carré (24) ayant la fréquence de référence (Fref) du signal de référence, et un dispositif d'extraction d'une harmonique (39) propre à sélectionner l'harmonique prédéterminée à générer par le générateur d'harmonique.

5. Générateur de fréquence selon l'une des revendications précédentes, **caractérisé en ce que** l'oscillateur local (3) est connecté par au moins deux voies (31, 33) parallèles et au moins un commutateur (27, 29) à la première entrée (16) de la boucle à verrouillage de phase (5), le ou les commutateurs étant propres à sélectionner l'une des voies.

6. Générateur de fréquence selon la revendication 5, **caractérisé en ce qu'**un premier commutateur (27) est connecté entre l'oscillateur local (3) et les au moins deux voies (31, 33) et un deuxième commutateur (29) est connecté entre les au moins deux voies (31, 33) et la première entrée (16) de la boucle à verrouillage de phase (5).

7. Générateur de fréquence selon la revendication 5 ou 6, **caractérisé en ce qu'il** est propre à appliquer le signal de référence ayant la fréquence de référence (Fref) à la première entrée (16) lors de la sélection d'une première voie (31).

8. Générateur de fréquence selon l'une des revendications 5 à 7, **caractérisé en ce qu'**au moins une deuxième voie (33) munie de l'un des générateurs d'harmonique (7) de façon que lors de la sélection d'une deuxième voie (33), le signal d'harmonique est appliqué à la première entrée (16).

9. Générateur de fréquence selon l'une des revendications 5 à 8, comprenant en outre un dispositif de sélection (11) propre à choisir l'une des voies (31, 33) en fonction de la fréquence de sortie ($F_s$) du signal de sortie à générer.

10. Procédé pour générer un signal de sortie ayant une fréquence de sortie ($F_s$) prédéterminée en utilisant un oscillateur local (3) pour générer un signal de référence ayant une fréquence de référence (Fref) et une boucle à verrouillage de phase (5), la boucle à verrouillage de phase étant munie d'un oscillateur contrôlé (25) générant le signal de sortie ayant la fréquence de sortie ($F_s$) en fonction d'un signal à son entrée, et d'un comparateur fournissant un signal au oscillateur contrôlé (25) en fonction d'une comparaison de phase et/ou de fréquence d'un premier signal de comparaison (Fcomp1) basé sur un signal d'entrée appliqué à une première entrée (16) de la boucle à verrouillage de phase (5) avec un deuxième signal de comparaison (Fcomp2) basé sur le signal de sortie ($F_s$), le procédé comprenant :

la sélection d'une fréquence à appliquer à la première entrée (16) parmi la fréquence de référence (Fref) de l'oscillateur local (3) et une fréquence d'harmonique prédéterminée ($F_H$) du signal de référence, la génération, à partir du signal de référence, d'un signal d'harmonique ayant la fréquence d'harmonique prédéterminée ($F_H$) du signal de référence, et l'application du signal d'harmonique à la première entrée (16) de la boucle à verrouillage de phase (5).

11. Procédé selon la revendication 10, **caractérisé en ce que** la sélection de la fréquence à appliquer à la première entrée (16) est faite en fonction de la fréquence de sortie ($F_s$) du signal de sortie.

## FIG.1

## FIG.2

## FIG.3

**EP 2 642 665 A1**

Europäisches
Patentamt

European
Patent Office

Office européen
des brevets

# RAPPORT DE RECHERCHE EUROPEENNE

Numéro de la demande

EP 13 15 9852

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 3 694 766 A (BOELKE GILBERT L) 26 septembre 1972 (1972-09-26) * colonne 3, ligne 2 - colonne 4, ligne 16; figure 1 * ----- | 1-8,10 | INV. H03L7/20 |
| X | US 3 064 199 A (BRABHAM HUGH B S) 13 novembre 1962 (1962-11-13) * colonne 2, ligne 45 - colonne 3, ligne 60; figure 1 * ----- | 1-8,10 | |
| A | US 5 343 168 A (GUTHRIE WARREN E [US]) 30 août 1994 (1994-08-30) * colonne 3, ligne 50 - colonne 5, ligne 29; figure 1 * ----- | 1-11 | |

DOMAINES TECHNIQUES RECHERCHES (IPC)

H03L

Le présent rapport a été établi pour toutes les revendications

| Lieu de la recherche | Date d'achèvement de la recherche | Examinateur |
|---|---|---|
| La Haye | 17 juin 2013 | Aouichi, Mohamed |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

....................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 13 15 9852

La présente annexe indique les membres de la famille de brevets relatifs aux documents brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

17-06-2013

| Document brevet cité au rapport de recherche | | | Date de publication | Membre(s) de la famille de brevet(s) | | Date de publication |
|---|---|---|---|---|---|---|
| US 3694766 | A | | 26-09-1972 | AUCUN | | |
| US 3064199 | A | | 13-11-1962 | GB<br>US | 863585 A<br>3064199 A | 22-03-1961<br>13-11-1962 |
| US 5343168 | A | | 30-08-1994 | DE<br>DE<br>EP<br>JP<br>JP<br>US<br>WO | 69404434 D1<br>69404434 T2<br>0659313 A1<br>3751316 B2<br>H08501431 A<br>5343168 A<br>9502282 A1 | 28-08-1997<br>27-11-1997<br>28-06-1995<br>01-03-2006<br>13-02-1996<br>30-08-1994<br>19-01-1995 |

EPO FORM P0460

Pour tout renseignement concernant cette annexe : voir Journal Officiel de l'Office européen des brevets, No.12/82